(19) Europäisches Patentamt / European Patent Office / Office européen des brevets

(11) **EP 3 324 434 B1**

(12) **EUROPEAN PATENT SPECIFICATION**

(45) Date of publication and mention
of the grant of the patent:
**18.08.2021 Bulletin 2021/33**

(51) Int Cl.:
*H01L 23/49* *(2006.01)*          *H01L 25/07* *(2006.01)*

(21) Application number: **16199238.3**

(22) Date of filing: **17.11.2016**

(54) **SEMICONDUCTOR ASSEMBLY WITH BONDING PEDESTAL AND METHOD FOR OPERATING SUCH SEMICONDUCTOR ASSEMBLY**

HALBLEITERANORDNUNG MIT BONDING-SOCKEL UND VERFAHREN ZUM BETRIEB SOLCH EINER HALBLEITERANORDNUNG

ENSEMBLE SEMI-CONDUCTEUR COMPRENANT UN SOCLE DE LIAISON ET PROCÉDÉ DE FONCTIONNEMENT D'UN TEL ENSEMBLE SEMI-CONDUCTEUR

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**23.05.2018 Bulletin 2018/21**

(73) Proprietor: **Infineon Technologies AG**
**85579 Neubiberg (DE)**

(72) Inventors:
 • **Laven, Johannes Georg**
 **82024 Taufkirchen (DE)**

 • **Müller, Christian Robert**
 **97421 Schweinfurt (DE)**

(74) Representative: **Westphal, Mussgnug**
 **Patentanwälte & Partner mbB**
 **Werinherstraße 79**
 **81541 München (DE)**

(56) References cited:
**TW-B- 405 192**          **US-A1- 2013 306 991**
**US-A1- 2016 056 132**    **US-B1- 9 443 792**

## Description

TECHNICAL FIELD

The instant disclosure relates to a semiconductor assembly and to a method for operating a semiconductor assembly.

BACKGROUND

Semiconductor assemblies are widely used in automotive, industrial, or consumer electronic applications for driving loads, converting power, or the like. Typically, a semiconductor assembly includes at least one semiconductor chip that is attached to a substrate and electrically connected to at least one further element of the semiconductor assembly by one or more bonding wires. Due to continuing development, the perpetually increasing power density of semiconductor chips leads to a shrink in chip size (i.e. to a shrink of the foot print area of the semiconductor chip) within semiconductor chips of the same power class. That is, the shrink in chip size causes the waste heat produced by low-size semiconductor chips during operation to concentrate on a small footprint area. Therefore, it may be desirable to mount the semiconductor chip on a large-area substrate conductor, e.g. a segment of a lead frame or a metallization of a circuit board, which may act as heat spreader. However, electrically connecting the semiconductor chip with a bonding wire can, depending on the circuit to be implemented, require the bonding wire to traverse a free section of a surface of the large-area conductor and, therefore, to traverse a long distance in a large loop which adversely affects the mechanical stability of the bonding wire loop.

The same or a similar problem can occur in other situations. For instance, in many cases it is desirable to populate identical substrates on corresponding substrate conductors, e.g. metallizations of a circuit board, with one or more semiconductor chips differently so that only one type of substrate needs to be stocked for the production of different semiconductor assemblies. For instance, the same kind of electronic circuit may be implemented with corresponding semiconductor chips of the same type (e.g. MOSFETs, IGBTs, diodes, etc.) but with different ratings (e.g. different rated currents, different voltage blocking capabilities, etc.). Doing so can result in corresponding locations of corresponding substrate conductors of identical substrates being populated with semiconductor chips having different footprint areas. When a semiconductor chip has a comparatively small footprint area, the surface of the substrate metallization carrying the semiconductor chip can include a free section that is not required for carrying (i.e. not covered by) the semiconductor chip. As above, electrically connecting the semiconductor chip with a bonding wire can, depending on the circuit to be implemented, require the bonding wire to traverse the free section and, therefore, to traverse a long distance in a large loop which adversely affects the mechanical stability of the bonding wire loop.

The same or a similar problem can occur in still other situations. For instance, a desired current rating of an electronic circuit realized on a substrate can be adjusted by changing the number of identical specific semiconductor chips that are commonly attached to the same substrate conductor and electrically connected in parallel. This means that, in case of an electronic circuit requiring a rated current which is lower than the maximum possible rated current that can be achieved using the specific semiconductor chips disposed on the substrate in question, there can remain a free section of a surface of the substrate conductor leading to the problems described above.

A further situation in which problems as described above can occur is when the electronic circuit includes a freewheeling diode electrically connected in parallel to a load path of a controllable semiconductor switch. Assemblies in which the controllable semiconductor switch is integrated in a first semiconductor chip and the freewheeling diode is integrated in a second semiconductor chip with both the first and second semiconductor chips being attached to the same substrate conductor can require more space on the surface of the substrate conductor than assemblies in which the controllable semiconductor switch and the freewheeling diode are integrated in a common semiconductor chip, as is the case, for instance, with RC-IGBTs (reverse conducting IGBTs).

Another problem that can arise with a large bonding wire loop traversing a substrate conductor or another electrically conductive element of the semiconductor assembly is that an electrical spark-over between the bonding wire and the traversed substrate conductor or the other electrically conductive element of the semiconductor assembly can occur.

US 2013/306991 A1 describes a semiconductor device in which a MOSFET and an insulating terminal table are arranged on an electrode pattern of an insulating substrate. The insulating terminal table includes an insulating material member made of resin, a relay terminal disposed on that side of the insulating material member facing away from the substrate, and a copper foil disposed on that side of the insulating material member facing towards the substrate. A wire extends from the relay terminal to that side of the MOSFET facing away from the substrate.

US 9 443 792 B1 discloses a semiconductor device in which an IGBT and a bridging DMB (DMB = direct metal bonded) structure are arranged on different islands of a substrate DMB structure. The bridging DMB structure includes a ceramic layer, a metallic island disposed on that side of the ceramic layer facing away from the substrate DMB structure, and a bottom direct bonded metal layer disposed on that side of the ceramic layer facing towards the substrate DMB structure. A wire extends from the metallic island to that side of the IGBT facing away from the substrate DMB structure. A similar semiconductor device is described in US 2016/056132 A1.

TW 405 192 B relates to an insulated structure of a bonding pad in a semiconductor integrated circuit. Two reverse connected P-N diodes are formed in a substrate in order to provide the object of insulation without leakage current. On top of the reverse connected P-N diodes, a bonding pad is formed, and a wire is bonded to the bonding pad.

A need has been identified for a semiconductor assembly preventing at least one of the problems that may be caused by large bonding wire loops.

SUMMARY

The invention is disclosed by the set of the appended claims. A first aspect relates to a semiconductor assembly. The semiconductor assembly includes a first semiconductor chip, a pedestal and a first bonding wire. The first semiconductor chip is disposed on a substrate and includes a first semiconductor body, a first chip electrode and a second chip electrode. The pedestal is disposed on the substrate and includes a second semiconductor body, a first pedestal electrode and a second pedestal electrode. The second pedestal electrode is electrically connected to the second chip electrode. The first bonding wire is, at a first bonding location, bonded to the first chip electrode and, at a second bonding location, to the first pedestal electrode. For each polarity of an electrical voltage applied between the first chip electrode and the second chip electrode, the magnitude of a breakdown voltage of the second semiconductor body is greater than the magnitude of a breakdown voltage of the first semiconductor body.

A second aspect relates to a method. The method includes applying a voltage, e.g. at least 300 V, between the first pedestal electrode and the second pedestal electrode of a semiconductor assembly. The semiconductor assembly includes a first semiconductor chip, a pedestal and a first bonding wire. The first semiconductor chip is disposed on a substrate and includes a first semiconductor body, a first chip electrode and a second chip electrode. The pedestal is disposed on the substrate and includes a second semiconductor body, a first pedestal electrode and a second pedestal electrode. The second pedestal electrode is electrically connected to the second chip electrode. The first bonding wire is, at a first bonding location, bonded to the first chip electrode and, at a second bonding location, to the first pedestal electrode. For each polarity of an electrical voltage applied between the first chip electrode and the second chip electrode, the magnitude of a breakdown voltage of the second semiconductor body between the first and second pedestal electrodes is greater than the magnitude of a breakdown voltage of the first semiconductor body between the first and second chip electrodes.

The invention may be better understood with reference to the following drawings and the description.

The components in the figures are not necessarily to scale, emphasis instead being placed upon illustrating the principles of the invention. Moreover, in the figures, like referenced numerals designate corresponding parts throughout the different views.

BRIEF DESCRIPTION OF THE DRAWINGS

Figure 1 is a cross-sectional side view illustrating a semiconductor assembly according to a first example.

Figure 2 is a top view illustrating the semiconductor assembly of Figure 1.

Figure 3 is an enlarged cross-sectional side view illustrating an example of a pedestal 3 that includes two rectifying junctions formed as pn-junctions.

Figure 4 is an enlarged cross-sectional side view illustrating an example of a pedestal 3 that includes two rectifying junctions formed as Schottky-junctions.

Figure 5 is a cross-sectional side view illustrating how a pedestal may be used to electrically connect two bonding wires having different cross-sectional areas.

Figure 6 illustrates the cross-sections of the two bonding wires having different cross-sectional areas shown in Figure 5.

Figure 7 is a cross-sectional side view illustrating how a pedestal may be used to electrically connect first chip electrodes of two semiconductor chips.

Figure 8 is a cross-sectional side view illustrating bonding wires bonded to the first pedestal electrode and having significantly different directions of extension.

DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise.

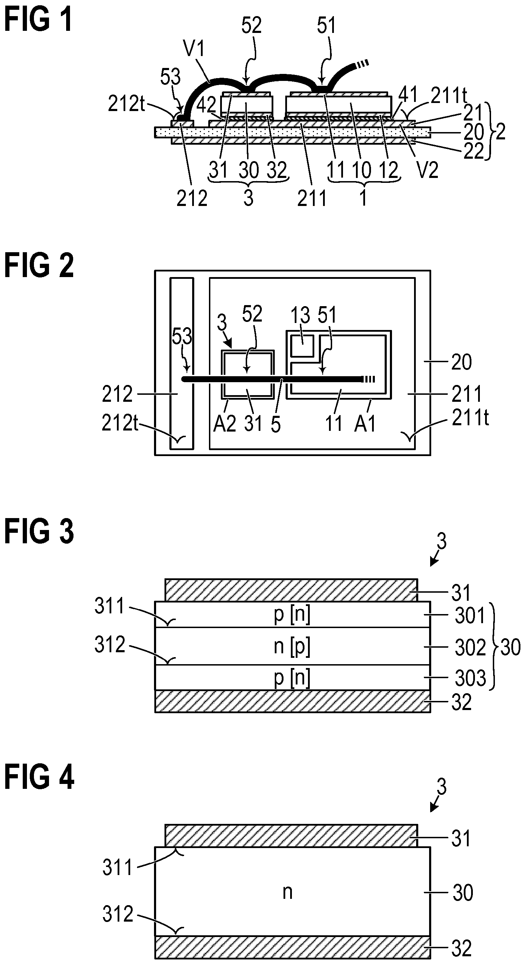

Figure 1 schematically illustrates an exemplary semiconductor assembly. A top view is shown in Figure 2. The semiconductor assembly includes a substrate 2, a semiconductor chip 1 attached to the substrate 2, a pedestal 3 attached to the substrate 2 adjacent to the semiconductor chip 1, and a first bonding wire 5. The semiconductor chip 1 includes a first semiconductor body 10 and at least two (here: three) chip electrodes 11, 12, 13 attached to the first semiconductor body 10. The pedestal 3 includes a second semiconductor body 30 and at least two pedestal electrodes 31, 32 attached to the second semiconductor body 30. The semiconductor assembly further includes at least a first bonding location 51 at which the bonding wire 5 is wire bonded and therefore electrically connected to a first one (11) of the chip electrodes, and a second bonding location 52 at which the bonding wire 5 is wire bonded and therefore electrically connected to a first one (31) of the pedestal electrodes. Optionally, the first and second bonding locations 51, 52 may be, along the direction of extension the bonding wires, adjacent bonding locations with no further bonding location in between.

The pedestal 3 serves to support the bonding wire 5 so that it is kept distant from a first conductor 211 in order to provide for a sufficient electrical insulation between the bonding wire 5 and the first conductor 211. This will be explained in further detail below.

In the sense of the present description, a bonding wire is wire bonded at a bonding location to a further element if the bonding wire directly contacts and forms a substance-to-substance-bond with the further element at the bonding location. Optionally, the further element may be electrically conductive. In this case, the bonding wire and the further element are also electrically connected at the bonding location. The production of wire bonded connections is commonly known in the art so that no further explanation is required in this regard.

Further, throughout the present description a chip electrode, to which the bonding wire 5 is wire bonded at the first bonding location 51, is referred to as "first chip electrode" and designated with reference numeral "11". Accordingly, a pedestal electrode, to which the bonding wire 5 is wire bonded at the second bonding location 52, is referred to as "first pedestal electrode" and designated with reference numeral "31".

The first semiconductor body 10 may include a monocrystalline or substantially monocrystalline semiconductor material, e.g., silicon, silicon carbide, gallium nitride, gallium arsenide, aluminium gallium arsenide, or any other semiconductor material that can be used for semiconductor devices, and may have one or more semiconductor regions doped with electrically active dopants, i.e. with dopants causing the respective semiconductor region to be n-doped or p-doped. For example, the first semiconductor body 10 may include at least one pn-junction formed between a p-doped semiconductor region and an n-doped semiconductor region.

Prior to being attached to the substrate 2 and prior to wire bonding the bonding wire 5 at the first bonding location 51 to the first chip electrode 11, the semiconductor chip 1 may already be packaged or, alternatively, be a bare semiconductor chip so that the first semiconductor body 10, i.e. a semiconductor material of the semiconductor body 10, is exposed.

The first semiconductor body 10 includes a semiconductor component which may be, for instance a diode, or a controllable semiconductor component like a unipolar or bipolar transistor or a thyristor, or any other semiconductor component. In case of a transistor, the controllable semiconductor component may be, for instance, an IGFET (Insulated Gate Field Effect Transistor) like a MOSFET (Metal Oxide Semiconductor Field-Effect Transistor) or an IGBT (Insulated Gate Bipolar Transistor; e.g. a reverse conducting IGBT), or a JFET (Junction Field Effect Transistor), a HEMT (High Electron Mobility Transistor), a BIP (Bipolar Transistor), or any other transistor.

Optionally, the semiconductor component may comprise a load path formed between two of the at least two chip electrodes 11, 12, 13. In the following, the chip electrodes between which the load path is formed are also referred to as "load electrodes". In case of a diode, the load electrodes are an anode electrode and a cathode electrode of the semiconductor chip 1. In case of a controllable semiconductor component, e.g. a transistor, the load electrodes may, depending on the type of controllable semiconductor component, be an anode electrode and a cathode electrode of the semiconductor chip 1, or a source electrode and a drain electrode of the semiconductor chip 1, or an emitter electrode and a collector electrode of the semiconductor chip 1. If the semiconductor component is controllable, the semiconductor chip 1 may also have an optional control electrode, e.g. a gate electrode or a base electrode, attached to the first semiconductor body 10 for controlling the load path of the semiconductor component. The types and the functional principle of the mentioned semiconductor components as well as the designation of the respective electrodes are commonly known in the art so that no further explanation is required in this regard.

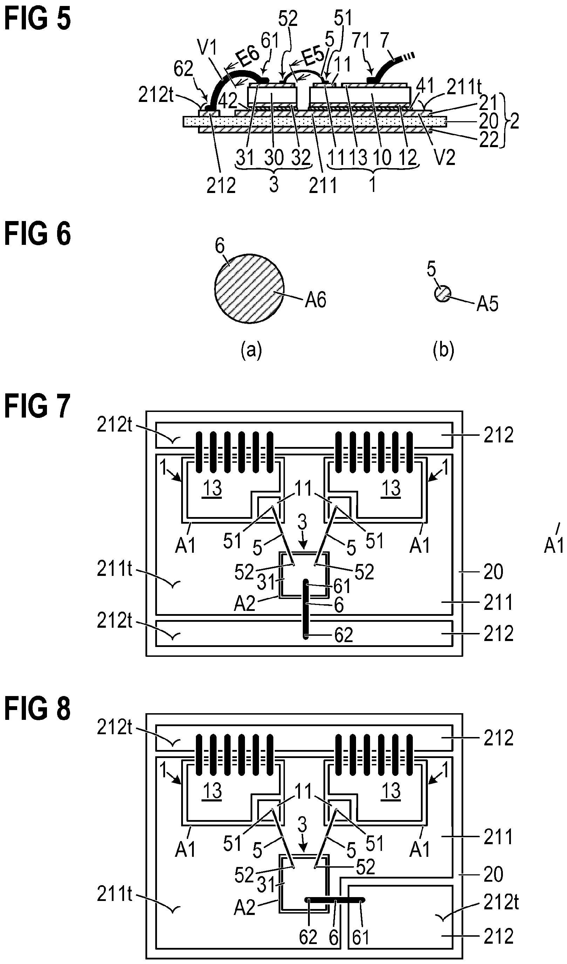

As illustrated in the example of Figures 1 and 2, the first chip electrode 11 may be a load electrode, e.g. an anode electrode or a cathode electrode or a source electrode or a drain electrode or an emitter electrode or a collector electrode of the semiconductor chip 1. However, this is only an example. For instance, the first chip electrode 11 may also be a control electrode, e.g. a gate electrode or a base electrode, as explained above. Examples of a semiconductor assembly, in which the first chip electrode 11 is a control electrode of the semiconductor chip 1, will be explained below with reference to Figures 5, 7 and 8. Generally, however, the first chip electrode 11 may be any kind of electrode that is attached to the first semiconductor body 10.

In the example of Figures 1 and 2, the load electrodes are formed by the chip electrodes 11 and 12. As demonstrated in particular in Figure 1, the load electrodes may be attached to opposite surfaces of the first semiconductor body 10. For instance, one of the load electrodes (here: 11) may be attached to a surface of the first semiconductor body 10 facing away from the substrate 2, and the other of the load electrodes (here: 12) may be attached to a further surface of the first semiconductor body 10 facing towards the substrate 2. However, this is only an example. Alternatively, both load electrodes may be attached side by side to the same surface of the first semiconductor body 10, e.g. to a surface of the first semiconductor body 10 facing away from the substrate 2.

In the example of Figures 1 and 2, the optional control electrode is formed by the chip electrodes 13. The control electrode may, irrespective of the positions of the load electrodes on the first semiconductor body 10, be attached to any surface of the first semiconductor body 10. As exemplarily illustrated in Figures 1 and 2, the control electrode (here: 13) may be attached to a surface of the first semiconductor body 10 facing away from the substrate 2. However, this is only an example. Alternatively, the control electrode may also be attached to a surface of the first semiconductor body 10 facing towards the substrate 2.

In order to facilitate the production of the wire bond connection between the bonding wire 5 and the first chip electrode 11 at the first bonding location 51, the first chip electrode 11 may, irrespective of its type, be attached to that surface of the first semiconductor body 10 that faces away from the substrate 2.

The substrate 2 may be any type of substrate having at least one (a first) conductor 211 with a first conductor surface 211t, i.e. the substrate 2 includes at least a one (the first) conductor surface 211t.

As illustrated in Figures 1 and 2, the substrate 2 may be a circuit board having a dielectric insulation carrier 20 to which the first conductor 211 is attached. Optionally, the substrate 2 may include at least one second conductor 212 that is attached to the same surface of the dielectric insulation carrier 20 as the first conductor 211. Each of the first and at least one second conductors 211, 212 are disposed distant from each one of the other of the first and at least one second conductors 211, 212. Further, each second conductor 212 has a corresponding second conductor surface 212t.

As illustrated in the example of Figures 1 and 2, the first conductor 211 and the at least one (if any) second conductor 212 may be sections of a first metallization layer 21 attached to the dielectric insulation carrier 20 and disposed distant from one another. Alternatively, a first metallization layer 21 may be identical with the first section 211, i.e. there is no second conductor 212 formed in the first metallization layer 21. Optionally, the substrate 2 may, irrespective of the layout of the first metallization layer 21, include a second metallization layer 22 attached to the dielectric insulation carrier 20 such that the first metallization layer 21 and the second metallization layer 22 are attached to opposite surfaces of the dielectric insulation carrier 20.

Even though Figure 1 illustrates a substrate 2 that has a dielectric insulation carrier 20 and at least one first conductor 211 attached to the dielectric insulation carrier 20, this is only an example. According to a further example, the first conductor 211 may also be a lead frame, or a section of a lead frame. Lead frames are commonly known in the art so that no further explanation is required in this regard.

Each of the first and second conductors 211, 212 (as far as one or more second conductors 212 are provided) may consist of or include one of the following materials: copper; a copper alloy; aluminium; an aluminium alloy; or any other metal or alloy that remains solid during the operation of the semiconductor assembly. In case of a substrate 2, the first metallization layer 21 and (if provided) the second metallization layer may consist of or include one of the following materials: copper; a copper alloy; aluminium; an aluminium alloy; or any other metal or alloy that remains solid during the operation of the semiconductor assembly.

According to one example, the substrate 2 may be a printed circuit board (PCB). For instance, the dielectric insulation carrier 20 may be a ceramic, e.g. a thin ceramic layer. The ceramic may, for example, consist of or include one of the following materials: aluminium oxide ($Al_2O_3$); aluminium nitride (AlN); zirconium oxide ($ZrO_2$); silicon nitride; boron nitride; or any other dielectric ceramic. The substrate 2 may, e.g., be a DCB substrate (DCB=Direct Copper Bonding), a DAB substrate (DAB=Direct Aluminium Bonding), or an AMB substrate (AMB=Active Metal Brazing). In other examples of a substrate 2 that is a printed circuit board, the dielectric insulation carrier 20 may be a non-ceramic dielectric. For instance, a dielectric insulation carrier 20 may consist of or include a resin.

The semiconductor chip 1 is, irrespective of the type of the substrate 2, attached to the first conductor surface 211t using a first connection layer 41. The first connection layer 41 directly adjoins both the first conductor surface 211t and a chip electrode (here: 12) attached to a surface of the first semiconductor body 10, said surface facing towards the substrate 2. The first connection layer 41 is electrically conductive in order to electrically connect the semiconductor chip 1 at the mentioned chip electrode (here: 12) to the first conductor surface 211t. A conductive first connection layer 41 may, for example, be a solder layer, a layer of a sintered metal powder (e.g. a sintered silver powder), or a layer of an electrically conductive adhesive.

As further can be seen, in particular in Figure 1, the first pedestal electrode 31 and a second pedestal electrode 32 may be attached to opposite surfaces of the second semiconductor body 30. In order to facilitate the production of the wire bond connection between the bonding wire 5 and the first pedestal electrode 31 at the second bonding location 52, the first pedestal electrode 31 may be attached to that surface of the second semiconductor body 30 facing away from the substrate 2. The second pedestal electrode 32 may be attached to that surface of the second semiconductor body 30 facing towards the substrate 2.

The second semiconductor body 30 includes a semiconductor material, e.g. a polycrystalline semiconductor material, or a monocrystalline or substantially monocrystalline semiconductor material. Suitable semiconductor materials are, e.g., silicon, silicon carbide, gallium nitride, gallium arsenide, aluminium gallium arsenide, or any other semiconductor material. Optionally, the second semiconductor body 30 may have one or more semiconductor regions doped with electrically active dopants, i.e. with dopants causing the respective semiconductor region to be n-doped or p-doped. Alternatively or in addition to electrically active dopants, the second semiconductor body 30 may include electrically inactive dopants. Alternatively, the second semiconductor body 30 may be intrinsic.

Employing a pedestal 3 having a second semiconductor body 30 with attached first and second pedestal electrodes 31, 32 allows for producing the pedestal 3 in conventional chip plants that may also be used for the production of other semiconductor chips and that may already be available. Further, a pedestal 3 having a second semiconductor body 30 with attached first and second pedestal electrodes 31, 32 may have similar properties (e.g. a similar coefficient of thermal expansion) as the semiconductor chip 1 which in some applications may be desired. However, this does not necessarily mean that the first and second semiconductor bodies 10, 30 need to be made from the same semiconductor material.

As further illustrated in Figures 1 and 2, the pedestal 3 may be attached to the substrate 2, for instance to the first conductor 211 (e.g. to the first conductor surface 211t), using a second connection layer 42. The second connection layer 42 directly adjoins both the first conductor (e.g. the first conductor surface 211t) and the second pedestal electrode 32. The second connection layer 42 is electrically conductive so that the second pedestal electrode 32 is electrically conductively connected to the first conductor 211. A conductive second connection layer 42 may, for example, be a solder layer, a layer of a sintered metal powder (e.g. a sintered silver powder), or a layer of an electrically conductive adhesive.

As can be seen from the example of Figures 1 and 2, the second chip electrode 12 and the second pedestal electrode 32 are electrically connected. The respective electrical connection formed by the first connection layer 41, the first conductor 211 and the second connection layer 42 is low-ohmic so that the electrical potentials of the first chip electrode 11 and the first pedestal electrode 31 are substantially identical. As the electrical connection between the first chip electrode 11 and the first pedestal electrode 31 formed by the first bonding wire 5 is also low-ohmic, the electrical potentials of the second chip electrode 12 and the second pedestal electrode 32 are also substantially identical. As a consequence, the electrical voltage between the first chip electrode 11 and the second chip electrode 12 is substantially identical with the electrical voltage between the first pedestal electrode 31 and the second pedestal electrode 32.

In the following, a voltage that is applied between the first and second chip electrodes 11, 12 and between the first and second pedestal electrodes 31, 32 is designated to have a "first polarity", if the first chip electrode 11 has an electric potential V1 higher than an electric potential V2 of the second chip electrode 12, and if the first pedestal electrode 31 has an electric potential V1 higher than an electric potential V1 of the second pedestal electrode 32. Accordingly, a voltage that is applied between the first and second chip electrodes 11, 12 and between the first and second pedestal electrodes 31, 32 is designated to have a "second polarity", if the first chip electrode 11 has an electric potential lower V1 than an electric potential V2 of the second chip electrode 12, and if the first pedestal electrode 31 has an electric potential V1 lower than an electric potential V2 of the second pedestal chip electrode 32.

When applying an electric voltage having a particular polarity between the first and second chip electrodes 11, 12, and when continuously increasing the magnitude of the voltage while maintaining its polarity, the voltage, at which an electrical break down occurs in the first semiconductor body 10 so that a significant current rise occurs between the first and second chip electrodes 11, 12, is defined as "breakdown voltage" of the first semiconductor chip 1. Accordingly, when applying an electric voltage having a particular polarity between the first and second pedestal electrodes 31, 32, and when continuously increasing the magnitude of the voltage while maintaining its polarity, the voltage, at which an electrical break down occurs in the second semiconductor body 30 so that a significant current rise occurs between the first and second pedestal electrodes 31, 32, is defined as "breakdown voltage" of the pedestal 3.

A break down voltage of the first semiconductor body 10 or the second semiconductor body 30 depends on the polarity of the voltage and the temperature of the first semiconductor body 10 or the second semiconductor body 30, respectively. That is, for a particular temperature of the first semiconductor body 10, there will be a first breakdown voltage for the first polarity, and a second breakdown voltage for the second polarity. Accordingly, for a particular temperature of the second semiconductor body 30, there will also be a first breakdown voltage for the first polarity, and a second breakdown voltage for the second polarity. It is to be noted that the magnitudes of the first breakdown voltage and the second breakdown voltage of the first semiconductor body 10 can but need not to be identical, and that the magnitudes of the first breakdown voltage and the second breakdown voltage of the second semiconductor body 30 can but need not to be identical. The reason for the occurrence of an electrical breakdown may be an avalanche or tunnel breakdown occurring in the respective semiconductor body 10 or 30.

When there is a controllable semiconductor component integrated in the first semiconductor body 10 so that a controllable load path of the semiconductor component is connected between the first chip electrode 11 and the second chip electrode 12, the first and second breakdown voltage of the first semiconductor body 10 can depend on a control voltage applied between a reference electrode (in the present example: 11 or 12) of the semiconductor chip 1 and a control electrode (here: 13) of the semiconductor chip 1. Depending on the type of semiconductor component, the reference electrode may be a source electrode, an emitter electrode or a cathode electrode. This is commonly known in the art so that no further explanation is required in this regard. In the sense of the present description, the first and second breakdown voltages of such a first semiconductor body 10 refer to a control voltage of 0 V. This applies for both normally-on and normally-off semiconductor components. Unless mentioned otherwise, statements concerning breakdown voltages of a first semiconductor body 10 relate to a control voltage of 0 V and a temperature of the first semiconductor body 10 of 20°C, and statements concerning breakdown voltages of a second semiconductor body 30 relate to a temperature of the second semiconductor body 30 of 20°C,

In order to provide for a sufficient electrical insulation between the first bonding wire 5 and the first conductor 211, for each polarity of an electrical voltage applied between the first chip electrode 11 and the second chip electrode 12 the magnitude of a breakdown voltage of the second semiconductor body 30 between the first and second pedestal electrodes 31, 32 is greater than the magnitude of a breakdown voltage of the first semiconductor body 10 between the first and second chip electrodes 11, 12. This means that each voltage which is applied between the first and second chip electrodes 11, 12 and which the first semiconductor body 10 can stand, the second semiconductor body 20 can also stand.

Optionally, for each polarity of an electrical voltage applied between the first chip electrode 11 and the second chip electrode 12, the magnitude of a breakdown voltage of the second semiconductor body 30 between the first and second pedestal electrodes 31, 32 is at least by 50 V or by 100 V or even by 200 V greater than the magnitude of a breakdown voltage of the first semiconductor body 10 between the first and second chip electrodes 11, 12.

According to a further option, the second semiconductor body 30 may have, for one or both polarities of a voltage applied between the first chip electrode 11 and the second chip electrode 12 (which is substantially identical to the voltage applied between the first pedestal electrode 31 and the second pedestal electrode 32), a breakdown voltage of at least 600 V, at least 1000 V, at least 3000 V or even at least 6000 V. That is, regarding both the first and second polarities it may be said that no avalanche and tunnel breakdown occurs in the second semiconductor body 30 between the first pedestal electrode 31 and the second pedestal electrode 32, if a voltage, which has the respective first or second polarity and which is less than or equal to a voltage blocking capability of the first semiconductor body 10 for this polarity, is applied between the first chip electrode 11 and the second pedestal electrode 12. The mentioned lower limits of the breakdown voltages may be useful for high voltage applications in which voltages significantly higher than 100 V are applied between the first and second chip electrodes 11 and 12.

According to still a further option, the semiconductor assembly may include an electrical circuit (e.g. a power converter) in which during operation a high voltage (e.g. a DC-link voltage of a power converter), for instance at least 300 V, at least 600 V or at least 1200 V, is applied between the first and second chip electrodes 11, 12. In such a semiconductor assembly, the second semiconductor body 30 has, for one or both polarities of a voltage applied between the first chip electrode 11 and the second chip electrode 12, a breakdown voltage of at least the DC-link voltage.

Figure 3 illustrates an example of a pedestal 3 that may be used in connection with any configuration of the semiconductor assembly. In order to provide for a sufficient bidirectional electrical insulation between the first pedestal electrode 31 and the second pedestal electrode 32 (for instance, in order to provide for a sufficient bidirectional electrical insulation between the bonding wire 5 and the first conductor 211), the second semiconductor body 30 may include a series connection of at least two rectifying junctions 311, 312 that is electrically connected between the first pedestal electrode 31 and the second pedestal electrode 32, wherein at least two (311, 312) of the rectifying junctions are connected in series in such a manner that a first one of the at least two (311, 312) rectifying junctions is in its blocking state when the first pedestal electrode 31 has an electrical potential higher than an electrical potential of the second pedestal electrode 32 (i.e. for the first polarity), and that a second one of the at least two (311, 312) rectifying junctions is in its blocking state when the second pedestal electrode 32 has an electrical potential higher than an electrical potential of the first pedestal electrode 31 (i.e. for the second polarity).

In the example of Figure 3, the first rectifying junction 311 is a pn-junction formed between a first semiconductor region 301 of a first conduction type (first doping type) and a second semiconductor region 302 of a second conduction type (second doping type) complementary to the first conduction type (first doping type). The second rectifying junction 312 is a pn-junction formed between the second semiconductor region 302 and a third semiconductor region 303 of the first conduction type (first doping type). According to a first alternative, the first conduction type may be "p" and the second conduction type may be "n", and according to a second alternative (illustrated in square brackets), the first conduction type may be "n" and the second conduction type may be "p". For the first alternative, the first pn-junction 311 is in its blocking state when the second pedestal electrode 32 has an electrical potential higher than an electrical potential of the first pedestal electrode 31 (i.e. for the second polarity), and the second pn-junction 312 is in its blocking state when the first pedestal electrode 31 has an electrical potential higher than an electrical potential of the second pedestal electrode 32 (i.e. for the first polarity). For the second alternative, the first pn-junction 311 is in its blocking state when the first pedestal electrode 31 has an electrical potential higher than an electrical potential of the second pedestal electrode 32 (i.e. for the first polarity), and the second pn-junction 312 is in its blocking state when the second pedestal electrode 32 has an electrical potential higher than an electrical potential of the first pedestal electrode 31 (i.e. for the second polarity).

One, more or all of the at least two rectifying junctions 311, 312 may be pn-junctions and/or Schottky-junctions. For instance, all of the at least two rectifying junctions 311, 312 may be pn-junctions, or all of the at least two rectifying junctions 311, 312 may be Schottky-junctions, or the entirety of the at least two rectifying junctions 311, 312 may include at least one pn-junction and at least one Schottky-junction.

An example of a pedestal 3 with a second semiconductor body 30 that includes two rectifying-junctions formed as Schottky-junctions is illustrated in Figure 4. The second semiconductor body 30 includes an n-doped region that extends between the first pedestal electrode 31 and the second pedestal electrode 32. The first rectifying Schottky-junction 311 is formed between the n-doped region and the first pedestal electrode 31, and the second rectifying Schottky-junction 312 is formed between the n-doped region and the second pedestal electrode 32. The first pn-junction 311 is in its blocking state when the second pedestal electrode 32 has an electrical potential higher than an electrical potential of the first pedestal electrode 31 (i.e. for the second polarity), and the second pn-junction 312 is in its blocking state when the first pedestal electrode 31 has an electrical potential higher than an electrical potential of the second pedestal electrode 32 (i.e. for the first polarity). Instead of an n-doped region that extends between the first pedestal electrode 31 and the second pedestal electrode 32, the second semiconductor body 30 could also have a structure similar to the example illustrated in Figure 3, i.e. a series connection with a p-doped second semiconductor region 302 connected in series between an n-doped first semiconductor region 301 adjoining the first pedestal electrode 31 and an n-doped third semiconductor region 303 adjoining the second pedestal electrode 32, so that the series connection is connected between the first pedestal electrode 31 and the second pedestal electrode 32. Thereby, at least one of the junctions formed between the n-doped first semiconductor region 301 and the first pedestal electrode 31 and between the n-doped third semiconductor region 303 and the second pedestal electrode 32 may be a rectifying Schottky-junction.

As already described with reference to Figures 1 and 2, the bonding wire 5 is, at a first bonding location 51, wire bonded and thereby electrically connected to the first chip electrode 11, and, at a second bonding location 52, wire bonded and thereby electrically connected to the first pedestal electrode 31. The first bonding location 51 and the second bonding location 52 may be the only bonding locations at which the bonding wire 5 is wire bonded to elements of the semiconductor assembly. Alternatively, as exemplarily illustrated in Figures 1 and 2, there may be more than the first and second bonding locations 51, 52 at which the bonding wire 5 is wire bonded to one or more elements of the semiconductor assembly different from the semiconductor chip 1 and the pedestal 3.

As illustrated in Figures 1, 2, the bonding wire 5 may, at a third bonding location 53, optionally be wire bonded to a second metal surface 212t of a second conductor 212 of the substrate 2. As illustrated, the second conductor 212 may be a section of the first metallization layer 21. Alternatively, the second conductor 212 may be a section of a lead frame. Instead to a second conductor 212 of the substrate 2, however, the bonding wire 5 may be wire bonded at the third bonding location 53 to any electrically conductive element of the semiconductor assembly that is different from the substrate 2, the semiconductor chip 1 to which the bonding wire 5 is wire bonded at the first bonding location 51, and the pedestal 3 to which the bonding wire 5 is wire bonded at the second bonding location 52. In order to illustrate that the bonding wire 5 may optionally be wire bonded at at least one further (fourth, fifth,...) bonding location to any electrically conductive element of the semiconductor assembly, in Figures 1 and 2 the right end of the bonding wire 5 is shown in dashed fashion.

As described with reference to Figures 1 and 2, the first chip electrode 11 may be a load electrode of a semiconductor component integrated in the first semiconductor body 10. Alternatively, the first chip electrode 11 may be a control electrode, e.g. a gate electrode or a base electrode, of a semiconductor component integrated in the first semiconductor body 10 for controlling a load path of that semiconductor component, wherein said load path is formed between chip (load) electrodes 11 and 13. As illustrated in both examples the size (footprint area) of the load electrode (11 in Figure 2 and 13 in Figure 5) may be greater than the size of the control electrode (13 in Figure 2 and 11 in Figure 5).

According to a further option also illustrated in Figure 5, the pedestal 3 may be used for forming an electrical connection between the first chip electrode 11 and a further element (which in Figure 5 is, just as an example, a second conductor 212 of the substrate 2) of the semiconductor assembly that includes bonding wires 5 and 6 having, out of bonding locations, different cross-sectional areas. The pedestal 3 may be used to "switch" from the bonding wire 5 to the bonding wire 6. In the example of Figure 5, a thin bonding wire 5 is, as described above, wire bonded at the first bonding location 51 to the first electrode 11, and at the second bonding location 52 to the first electrode 11. Further, a thick bonding wire 6, i.e. a bonding wire 6 having, outside of bonding locations, a cross-sectional area greater than a cross-sectional area of the bonding wire 5 is wire bonded at a third bonding location 61 to the first electrode 11, and, at a fourth bonding location 62, to a further element (here, just as an example, a second conductor 212 of the substrate 2) of the semiconductor assembly. The mentioned cross-sectional areas refer to cross-sections taken perpendicularly to the direction of extension of the respective bonding wire 5, 6. Figure 6 (a) shows a cross-sectional area A6 of the second bonding wire 6 of Figure 5 taken in a cross-sectional plane E6, and Figure 6 (b) shows a cross-sectional area A5 of the first bonding wire 5 of Figure 5 taken in a cross-sectional plane E5. It is to be noted that at least one of the first and second bonding wires 5, 6 may optionally have, out of bonding locations 51, 52, 53, 61, 62, a circular cross-section. Alternatively or in addition, at least one of the first and second bonding wires 5, 6 may optionally have, out of bonding locations 51, 52, 53, 61, 62, a non-circular (e.g. rectangular or substantially rectangular) cross-section.

Using a "thin" first bonding wire 5, i.e. a first bonding wire 5 having a small cross-sectional area A5, may be useful in particular if the first chip electrode 11 is a non-load electrode of the semiconductor chip 1, e.g. a control electrode or a sense electrode (e.g. for tapping a temperature signal or any other low power signal). A thin bonding wire 5 allows for using a first chip electrode 11 having a small size, i.e. a small footprint area, in order to make room for increasing a load electrode (here: the load electrode 13) attached to the same surface of the first semiconductor body 10 as the first (small size) chip electrode 11. For instance, the first bonding wire 5 may have, out of bonding locations 51, 52, 53 and perpendicularly to a direction of extension of the first bonding wire 5, a first cross sectional area A5, and the second bonding wire 6 may have, out of bonding locations 61, 62 and perpendicularly to a direction of extension of the second bonding wire 6, a second cross sectional area A6 that is at least 10-times or even at least 30-times the first cross sectional area A5.

According to a further option illustrated in Figure 7, the first chip electrodes 11 of each of at least two semiconductor chips 1 may be electrically connected, via a first bonding wire 5 in each case, to the same first pedestal electrode 31 of a pedestal 3 in order to electrically interconnect these first chip electrodes 11. That is, for each of the semiconductor chips 1, there is a first bonding wire 5 which is, at a first bonding location 51, wire bonded to the first chip electrode 11 of the respective semiconductor chip 1, and, at a second bonding location 52, wire bonded to the first pedestal electrode 31. According to one example, all first electrodes 11 may be control electrodes. According to a further example, all first electrodes 11 may be load electrodes. According to still a further example, at least one of all first electrodes 11 may be a control electrode and at least one of all first electrodes 11 may be a load electrode.

If at least two first chip electrodes 11 are control electrodes, a common control signal (e.g. a gate or base voltage) for controlling load paths of the controllable semiconductor components integrated in the first semiconductor bodies 10 of the semiconductor chips 1 that is provided via a further element of the semiconductor assembly (e.g. the a second conductor 212 as illustrated in Figure 7) may be supplied to the interconnected first chip electrodes 11 via a further bonding wire 6 which is, at a third bonding location 61, wire bonded to the first pedestal electrode 31, and, at a fourth bonding location 62, wire bonded to the second conductor 212. That is, the first pedestal electrode 31 helps distributing the control signal to the first chip electrodes 11.

According to a further option illustrated in Figure 8 that is substantially based on Figure 7, a pedestal 3 may be used in combination with bonding wires 5 and 6 having significantly different directions of extensions.

Optionally, the bonding pedestal 3 may serve to dissipate waste heat produced in the first bonding wire 5 and the semiconductor chip 1 towards the first conductor 211. In order to prevent the first semiconductor chip 1 from being heated by the waste heat produced in the first bonding wire 5, the thermal resistance of the second semiconductor body 30 may be appropriately adjusted so that during operation, the temperature of the first pedestal electrode 31 does not exceed the temperature of the first chip electrode 11. For instance, if the first semiconductor body 10 has (at a temperature of 20°C) a first thermal resistance Rth1 between the first chip electrode 11 and the second chip electrode 12, and the second semiconductor body 30 has (at a temperature of 20°C) a second thermal resistance Rth2 between the first pedestal electrode 31 and the second pedestal electrode 32, the second thermal resistance Rth2 may be less than 100-times, less than 10-times, less than twice the first thermal resistance Rth1, or even or even less than the first thermal resistance Rth1. In order to achieve a low second thermal resistance Rth2, the second semiconductor body 30 may be designed such that it does not include a dielectric between the first pedestal electrode 31 and the second pedestal electrode 32. Examples of such a second semiconductor body 30 are illustrated in Figures 3 and 4.

The first semiconductor body 10 has, when being parallel projected onto the insulation carrier 20, a first footprint area A1, and the second semiconductor body 30 has, when being parallel projected onto the insulation carrier 20, a second footprint area A2. Then, a first ratio r1 = Rht1/A1 between the first thermal resistance Rth1 and the first footprint area A1 can be determined, and a second ratio r2 = Rht2/A2 between the second thermal resistance Rth2 and the second footprint area A2 can be determined. Optionally, the second ratio r2 may be less than 100-times, less than 10-times, less than 5-times, less than twice the first ratio r1, or even less than the first ratio r1.

Apart from electrically insulating the first bonding wire 5 from the first conductor 211, a bonding pedestal 3 as described above may have no electrical function in the electrical circuit of the semiconductor assembly. A semiconductor assembly as described above may be operated so that the magnitude of the electrical current flowing between the first pedestal electrode 31 and the second pedestal electrode 32 through the second semiconductor body 30 does never exceed 100 μA, 10 μA, or even 1 μA. Alternatively or additionally, a semiconductor assembly as described above may be operated so that at no point of time the magnitude of an electrical current flowing between the first pedestal electrode 31 and the second pedestal electrode 32 through the second semiconductor body 30 exceeds a tenth, a hundredth or even a thousandth of the magnitude of the electrical current flowing at that point of time between the first chip electrode 11 and the second chip electrode 12 through the first semiconductor body 10.

However, it is also possible that the pedestal 3 fulfills an electrical function. According to one example, a capacity of the pedestal 3 may be used to add a capacity (i.e. the capacity of the pedestal 3) to a capacity which the semiconductor chip 1 has between the first chip electrode 11 and the second chip electrode 12. In doing so, a desired switching behavior of the semiconductor chip 1 may be reached.

A capacity of the pedestal 3 may be adjusted by the size (foot print area) of the first and second pedestal electrodes 31, 32, the distance between the first and second pedestal electrodes 31, 32, and the material and doping of the second semiconductor body 30. As the second semiconductor body 30 includes a semiconductor material, the capacity of the pedestal 3 can change with the voltage applied between the first and second pedestal electrodes 31, 32. This effect may, for instance, be used to compensate for undesired voltage-depending effects of the electronic circuit. For example, the second semiconductor body 30 alone (i.e. without the first and second pedestal electrodes 31, 32) may have, for both the first polarity and the second polarity, a capacity C that is proportional to the reciprocal of the square root of the voltage U applied between the first and second pedestal electrodes 31, 32 (at least within a voltage range between 0 V and 200 V). That is, C is approximately proportional to $1/\sqrt{U}$. For instance, in the mentioned voltage range from 0 V to 200 V, C may be, for each of the first and second polarity of U and for a constant temperature of the second semiconductor body 30 of 20°C, within a range from $0.9 \cdot K/\sqrt{U}$ and $1.1 \cdot K/\sqrt{U}$, wherein K is a constant greater zero.

Even though the semiconductor assemblies of the examples described above show only one pedestal 3 it shall be understood that a semiconductor assembly may contain any desired number of pedestals 3.

## Claims

1. A semiconductor assembly comprising:

   a first semiconductor chip (1) disposed on a substrate (2) and comprising a first semiconductor body (10), a first chip electrode (11) and a second chip electrode (12); and
   a pedestal (3) disposed on the substrate (2) and comprising a first pedestal electrode (31) and a second pedestal electrode (32), the second pedestal electrode (22) being electrically connected to the second chip electrode (12);
   a first bonding wire (5) which is, at a first bonding location (51), bonded to the first chip electrode (11) and, at a second bonding location (52), to the first pedestal electrode (31);

   **characterized in that**

   the pedestal (3) comprises a second semiconductor body (30);
   for each polarity of an electrical voltage applied between the first chip electrode (11) and the second chip electrode (12), the magnitude of a breakdown voltage of the second semiconductor body (30) is greater than the magnitude of a breakdown voltage of the first semiconductor body (10).

2. The semiconductor assembly of claim 1, wherein:

   for each polarity of an electrical voltage applied between the first chip electrode (11) and the second chip electrode (12), the magnitude of a breakdown voltage of the second semiconductor body (30) between the first and second pedestal electrodes (31, 32) is at least by 50 V greater than the magnitude of a breakdown voltage of the first semiconductor body (10) between the first and second chip electrodes (11, 12).

3. The semiconductor assembly of one of claims 1 or 2, wherein:

   the substrate (2) comprises a first conductor (211);
   the semiconductor chip (1) is disposed on the first conductor (211) and is, at the second chip electrode (12), electrically connected to the first conductor (211); and
   the pedestal (3) is disposed on the first conductor (211) and is, at the second pedestal electrode (32), joined to the first conductor (211).

4. The semiconductor assembly of claim 3, wherein:

   the substrate (2) comprises a second conductor (212) disposed distant from the first conductor (211); and
the first bonding wire (5) is, at a third bonding location (53), bonded to the second conductor (212).

5. The semiconductor assembly of claim 4, wherein:

the second bonding location (52) is, in a direction of extension of the first bonding wire (5), disposed between the first bonding location (51) and the third bonding location (53).

6. The semiconductor assembly of claim 5 and of any of claims 1 to 3 further comprising a second bonding wire (6) that is, at a fourth bonding location (61), bonded to the first pedestal electrode (31).

7. The semiconductor assembly of claim 6, wherein:

the substrate (2) comprises a second conductor (212) disposed distant from the first conductor (211); and
the second bonding wire (6) is, at a fifth bonding location (62), bonded to the second conductor (212).

8. The semiconductor assembly of any of claims 6 or 7, wherein:

the first bonding wire (5) comprises, out of bonding locations (51, 52, 53) and perpendicularly to a direction of extension of the first bonding wire (5), a first cross sectional area (A5); and
the second bonding wire (6) comprises, out of bonding locations (61, 62) and perpendicularly to a direction of extension of the second bonding wire (6), a second cross sectional area (A6) that is at least 10-times the first cross sectional area (A5).

9. The semiconductor assembly of any of the preceding claims, wherein:

the second semiconductor body (30) comprises a series circuit with two diodes connected back-to-back between the first pedestal electrode (31) and the second pedestal electrode (32).

10. The semiconductor assembly of any of the preceding claims, wherein:

the second semiconductor body (30) comprises, for at least one polarity of a voltage applied between the first chip electrode (11) and the second chip electrode (12), a breakdown voltage of at least 600 V.

11. The semiconductor assembly of any of the preceding claims, wherein:

the first semiconductor body (10) comprises a controllable semiconductor switch comprising a load path electrically connected between the first chip electrode (11) and the second chip electrode (12).

12. The semiconductor assembly of any of the preceding claims, wherein there is no dielectric disposed in the second semiconductor body (30) between the first pedestal electrode (31) and the second pedestal electrode (32).

13. The semiconductor assembly of any of the preceding claims, wherein:

the second semiconductor body (30) has, for both the first polarity and the second polarity of a voltage U applied between the first pedestal electrode (31) and the second pedestal electrode (32) and within a range from 0 V and 200 V of the voltage U, a capacity within a range from $0.9 \cdot K/\sqrt{U}$ and $1.1 \cdot K/\sqrt{U}$, wherein K is a constant greater zero.

14. The semiconductor assembly of any of the preceding claims wherein:

the first semiconductor body (10) comprises, between the first chip electrode (11) and the second chip electrode (12), a first thermal resistance;
the second semiconductor body (30) comprises, between the first pedestal electrode (31) and the second pedestal electrode (32), a second thermal resistance; and
the second thermal resistance is less than or equal to 100-times the first thermal resistance.

15. A method comprising:

applying a voltage between a first pedestal electrode (31) and a second pedestal electrode (32) of a semiconductor assembly which comprises:
a first semiconductor chip (1) disposed on a substrate (2) and comprising a first semiconductor body (10), a first chip electrode (11) and a second chip electrode (12); and
a pedestal (3) disposed on the substrate (2) and comprising the first pedestal electrode (31) and the
second pedestal electrode (32), the second pedestal electrode (32) being electrically connected to the second chip electrode (12);
a first bonding wire (5) which is, at a first bonding location (51), bonded to the first chip electrode

(11) and, at a second bonding location (52), to the first pedestal electrode (31);

wherein the semiconductor assembly is **characterized in that**

the pedestal (3) comprises a second semiconductor body (30);
for each polarity of an electrical voltage applied between the first chip electrode (11) and the second chip electrode (12), the magnitude of a breakdown voltage of the second semiconductor body (30) is greater than the magnitude of a breakdown voltage of the first semiconductor body (10).

**Patentansprüche**

1. Halbleiteranordnung, umfassend:

einen ersten Halbleiterchip (1), der auf einem Substrat (2) angeordnet ist und der einen ersten Halbleiterkörper (10), eine erste Chipelektrode (11) und eine zweite Chipelektrode (12) umfasst; und
einen Sockel (3), der auf dem Substrat (2) angeordnet ist und der eine erste Sockelelektrode (31) und eine zweite Sockelelektrode (32) umfasst, wobei die zweite Sockelelektrode (22) mit der zweiten Chipelektrode (12) elektrisch verbunden ist;
einen ersten Bonddraht (5), der an einer ersten Bondstelle (51) an die erste Chipelektrode (11) gebondet ist, und an einer zweiten Bondstelle (52) an die erste Sockelelektrode (31) gebondet ist;

**dadurch gekennzeichnet, dass**,

der Sockel (3) einen zweiten Halbleiterkörper (30) umfasst;
für jede Polarität einer elektrischen Spannung, die zwischen der ersten Chipelektrode (11) und der zweiten Chipelektrode (12) angelegt wird, die Größe einer Durchbruchspannung des zweiten Halbleiterkörpers (30) größer als die Größe einer Durchbruchspannung des ersten Halbleiterkörpers (10) ist.

2. Halbleiteranordnung nach Anspruch 1, wobei:

für jede Polarität einer elektrischen Spannung, die zwischen der ersten Chipelektrode (11) und der zweiten Chipelektrode (12) angelegt wird, die Größe einer Durchbruchspannung des zweiten Halbleiterkörpers (30) zwischen der ersten und der zweiten Sockelelektrode (31, 32) mindestens um 50 V größer als die Größe einer Durchbruchspannung des ersten Halbleiterkörpers (10) zwischen der ersten und der zweiten Chipelektrode (11, 12) ist.

3. Halbleiteranordnung nach einem der Ansprüche 1 oder 2, wobei:

das Substrat (2) eine erste Leiterbahn (211) umfasst;
der Halbleiterchip (1) auf der ersten Leiterbahn (211) angeordnet ist und an der zweiten Chipelektrode (12) mit der ersten Leiterbahn (211) elektrisch verbunden ist; und
der Sockel (3) auf der ersten Leiterbahn (211) angeordnet ist und an der zweiten Sockelelektrode (32) an die erste Leiterbahn (211) angeschlossen ist.

4. Halbleiteranordnung nach Anspruch 3, wobei:

das Substrat (2) eine zweite Leiterbahn (212) umfasst, die mit einem Abstand zur ersten Leiterbahn (211) angeordnet ist; und
der erste Bonddraht (5) an einer dritten Bondstelle (53) an die zweite Leiterbahn (212) gebondet ist.

5. Halbleiteranordnung nach Anspruch 4, wobei:

die zweite Bondstelle (52) in einer Richtung einer Ausdehnung des ersten Bonddrahts (5) zwischen der ersten Bondstelle (51) und der dritten Bondstelle (53) angeordnet ist.

6. Halbleiteranordnung nach Anspruch 5 und nach einem der Ansprüche 1 bis 3, die außerdem einen zweiten Bonddraht (6) umfasst, der an einer vierten Bondstelle (61) an die erste Sockelelektrode (31) gebondet ist.

7. Halbleiteranordnung nach Anspruch 6, wobei:

das Substrat (2) eine zweite Leiterbahn (212) umfasst, die mit einem Abstand zur ersten Leiterbahn (211) angeordnet ist; und
der zweite Bonddraht (6) an einer fünften Bondstelle (62) an die zweite Leiterbahn (212) gebondet ist.

8. Halbleiteranordnung nach einem der Ansprüche 6 oder 7, wobei:

der erste Bonddraht (5) außerhalb der Bondstellen (51, 52, 53) und senkrecht zu einer Richtung der Ausdehnung des ersten Bonddrahts (5) eine erste Querschnittsfläche (A5) umfasst; und
der zweite Bonddraht (6) außerhalb der Bondstellen (61, 62) und senkrecht zu einer Richtung der Ausdehnung des zweiten Bonddrahts (6) eine zweite Querschnittsfläche (A6) umfasst, die mindestens 10-mal so groß wie die erste Querschnittsfläche (A5) ist.

9. Halbleiteranordnung nach einem der vorhergehenden Ansprüche, wobei:

der zweite Halbleiterkörper (30) eine Reihenschaltung mit zwei Dioden aufweist, die entgegengesetzt zueinander zwischen die erste Sockelelektrode (31) und die zweite Sockelelektrode (32) geschaltet sind.

10. Halbleiteranordnung nach einem der vorhergehenden Ansprüche, wobei:

der zweite Halbleiterkörper (30) für mindestens eine Polarität einer Spannung, die zwischen der ersten Chipelektrode (11) und der zweiten Chipelektrode (12) angelegt wird, eine Durchbruchspannung von mindestens 600 V umfasst.

11. Halbleiteranordnung nach einem der vorhergehenden Ansprüche, wobei:

der erste Halbleiterkörper (10) einen steuerbaren Halbleiterschalter umfasst, der eine Laststrecke umfasst,
die zwischen der ersten Chipelektrode (11) und der zweiten Chipelektrode (12) elektrisch eingebunden ist.

12. Halbleiteranordnung nach einem der vorhergehenden Ansprüche, wobei in dem zweiten Halbleiterkörper (30) zwischen der ersten Sockelelektrode (31) und der zweiten Sockelelektrode (32) kein Dielektrikum angeordnet ist.

13. Halbleiteranordnung nach einem der vorhergehenden Ansprüche, wobei:

der zweite Halbleiterkörper (30) sowohl für die erste Polarität als auch die zweite Polarität einer Spannung U,
die zwischen der ersten Sockelelektrode (31) und der zweiten Sockelelektrode (32) angelegt wird, und innerhalb eines Bereichs von 0 V und 200 V der Spannung U, eine Kapazität innerhalb eines Bereichs von $0,9 \bullet K/\sqrt{U}$ bis $1,1 \bullet K/\sqrt{U}$ aufweist, wobei K eine Konstante größer als Null ist.

14. Halbleiteranordnung nach einem der vorhergehenden Ansprüche, wobei:

der erste Halbleiterkörper (10) zwischen der ersten Chipelektrode (11) und der zweiten Chipelektrode (12) einen ersten thermischen Widerstand umfasst;
der zweite Halbleiterkörper (30) zwischen der ersten Sockelelektrode (31) und der zweiten Sockelelektrode (32) einen zweiten thermischen Widerstand umfasst; und
wobei der zweite thermische Widerstand geringer als oder gleich 100-mal so groß wie der erste thermische Widerstand ist.

15. Verfahren, umfassend:

Anlegen einer Spannung zwischen einer ersten Sockelelektrode (31) und einer zweiten Sockelelektrode (32) einer Halbleiteranordnung, die umfasst:

einen ersten Halbleiterchip (1), der auf einem Substrat (2) angeordnet ist und der einen ersten Halbleiterkörper (10), eine erste Chipelektrode (11) und eine zweite Chipelektrode (12) umfasst; und
einen Sockel (3), der auf dem Substrat (2) angeordnet ist und der die erste Sockelelektrode (31) und die zweite Sockelelektrode (32) umfasst, wobei die zweite Sockelelektrode (32) mit der zweiten Chipelektrode (12) elektrisch verbunden ist;
einen ersten Bonddraht (5), der an einer ersten Bondstelle (51) an die erste Chipelektrode (11) gebondet ist, und an einer zweiten Bondstelle (52) an die erste Sockelelektrode (31) gebondet ist;
wobei die Halbleiteranordnung **dadurch gekennzeichnet ist, dass**
der Sockel (3) einen zweiten Halbleiterkörper (30) umfasst;
für jede Polarität einer elektrischen Spannung, die zwischen der ersten Chipelektrode (11) und der zweiten Chipelektrode (12) angelegt wird, die Größe einer Durchbruchspannung des zweiten Halbleiterkörpers (30) größer als die Größe einer Durchbruchspannung des ersten Halbleiterkörpers (10) ist.

**Revendications**

1. Ensemble à semi-conducteur comprenant :

une première puce (1) à semi-conducteur disposée sur un substrat (2) et comprenant un premier corps (10) semi-conducteur, une première électrode (11) de puce et une deuxième électrode (12) de puce ; et

un socle (3) disposé sur le substrat (2) et comprenant une première électrode (31) de socle et une deuxième électrode (32) de socle, la deuxième électrode (32) de socle étant connectée électriquement à la deuxième électrode (12) de puce ;

un premier fil (5) de liaison qui, à un premier emplacement (51) de liaison, est lié à la première électrode (11) de puce et, à un deuxième emplacement (52) de liaison, à la première électrode (31) de socle ;

**caractérisé en ce que**

le socle (3) comprend un deuxième corps (30) semi-conducteur ;

pour chaque polarité d'une tension électrique appliquée entre la première électrode (11) de puce et la deuxième électrode (12) de puce, la valeur d'une tension de claquage du deuxième corps (30) semi-conducteur est plus grande que la valeur d'une tension de claquage du premier corps (10) semi-conducteur.

2.  Ensemble à semi-conducteur suivant la revendication 1, dans lequel :

pour chaque polarité d'une tension électrique appliquée entre la première électrode (11) de puce et la deuxième électrode (12) de puce, la valeur d'une tension de claquage du deuxième corps (30) semi-conducteur entre les première et deuxième électrodes (31, 32) de socle est plus grande d'au moins 50 V que la valeur d'une tension de claquage du premier corps (10) semi-conducteur entre les première et deuxième électrodes (11, 12) de puce.

3.  Ensemble à semi-conducteur suivant l'une des revendications 1 ou 2, dans lequel :

le substrat (2) comprend un premier conducteur (211) ;

la puce (1) à semi-conducteur est disposée sur le premier conducteur (211) et est, à la deuxième électrode (12) de puce, connectée électriquement au premier conducteur (211) ; et

le socle (3) est disposé sur le premier conducteur (211) et est, à la deuxième électrode (32) de socle, joint au premier conducteur (211).

4.  Ensemble à semi-conducteur suivant la revendication 3, dans lequel :

le substrat (2) comprend un deuxième conducteur (212) disposé à distance du premier conducteur (211) ;

le premier fil (5) de liaison est, à un troisième emplacement (53) de liaison, lié au deuxième conducteur (212).

5.  Ensemble à semi-conducteur suivant la revendication 4, dans lequel :

le deuxième emplacement (52) de liaison est, dans une direction dans lequel le premier fil (5) de liaison s'étend, disposé entre le premier emplacement (51) de liaison et le troisième emplacement (53) de liaison.

6.  Ensemble à semi-conducteur suivant la revendication 5 et l'une quelconque des revendications 1 à 3, comprenant en outre un deuxième fil (6) de liaison qui est, à un quatrième emplacement (161) de liaison, lié à la première électrode (31) de socle.

7.  Ensemble à semi-conducteur suivant la revendication 6, dans lequel :

le substrat (2) comprend un deuxième conducteur (212) disposé à distance du premier conducteur (211) ;

le deuxième fil (6) de liaison est, à un cinquième emplacement (62) de liaison, lié au deuxième conducteur (212).

8.  Ensemble à semi-conducteur suivant la revendication 6 ou 7, dans lequel :

le premier fil (5) de liaison comprend, en dehors des emplacements (51, 52, 53) de liaison et perpendiculairement à une direction dans laquelle s'étend le premier fil (5) de liaison, une première surface (A5) de section transversale ;

le deuxième fil (6) de liaison comprend, en dehors des emplacements (61, 62) de liaison et perpendiculairement à une direction dans laquelle s'étend le deuxième fil (6) de liaison, une deuxième surface (a6) de section transversale qui représente au moins dix fois la première surface (a5) de section transversale.

9.  Ensemble à semi-conducteur suivant l'une quelconque des revendications précédentes dans lequel :

le deuxième corps (30) semi-conducteur comprend un circuit série ayant deux diodes montées tête-bêche entre la première électrode (31) de socle et la deuxième électrode (32) de socle.

10. Ensemble à semi-conducteur suivant l'une quelconque des revendication précédentes, dans lequel :

le deuxième corps (30) semi-conducteur comprend, pour au moins une polarité d'une tension appliquée entre la première électrode (11) de puce et la deuxième électrode (12) de puce, une tension de claquage d'au moins 600 V.

11. Ensemble à semi-conducteur suivant l'une quelconque des revendication précédentes, dans lequel :

le premier corps (10) semi-conducteur comprend un interrupteur à semi-conducteur pouvant être commandé, comprenant un trajet de charge montée électriquement entre la première électrode (11) de puce et la deuxième électrode (12) de puce.

12. Ensemble à semi-conducteur suivant l'une quelconque des revendication précédentes, dans lequel il n'y a pas de diélectrique disposé dans le deuxième corps (30) semi-conducteur entre la première électrode (31) de socle et la deuxième électrode (32) de socle.

13. Ensemble à semi-conducteur suivant l'une quelconque des revendication précédentes, dans lequel :

le deuxième corps (30) semi-conducteur a, pour à la fois la première polarité et la deuxième polarité d'une tension U appliquée entre la première électrode (31) de socle et la deuxième électrode (32) de socle et dans une plage allant de 0 V à 200 V de la tension U, une capacité dans une plage allant de $0,9 \ K/\sqrt{U}$ à $1,1 \ K/\sqrt{U}$, K étant une constante plus grande que zéro.

14. Ensemble à semi-conducteur suivant l'une quelconque des revendication précédentes, dans lequel

le premier corps (10) semi-conducteur comprend, entre la première électrode (11) de puce et la deuxième électrode (12) de puce, une première résistance thermique,
le deuxième corps (30) semi-conducteur comprend, entre la première électrode (31) de socle et la deuxième électrode (32) de socle, une deuxième résistance thermique ;
la deuxième résistance thermique est inférieure ou égale à 100 fois la première résistance thermique.

15. Procédé dans lequel :

on applique une tension entre une première électrode (31) de socle et une deuxième électrode (32) de socle d'un ensemble à semi-conducteur qui comprend :

une première puce (1) à semi-conducteur disposée sur un substrat (2) et comprenant un premier corps (10) semi-conducteur, une première électrode (11) de puce et une deuxième électrode (12) de puce ; et
un socle (3) disposé sur le substrat (2) et comprenant une première électrode (31) de socle et une deuxième électrode (32) de socle, la deuxième électrode (32) de socle étant connectée électriquement à la deuxième électrode (12) de puce ;
un premier fil (5) de liaison qui, à un premier emplacement (51) de liaison, est lié à la première électrode (11) de puce et, à un deuxième emplacement (52) de liaison, à la première électrode (31) de socle ;

**caractérisé en ce que**

le socle (3) comprend un deuxième corps (30) semi-conducteur ;
pour chaque polarité d'une tension électrique appliquée entre la première électrode (11) de puce et la deuxième électrode (12) de puce, la valeur d'une tension de claquage du deuxième corps (30) semi-conducteur est plus grande que la valeur d'une tension de claquage du premier corps (10) semi-conducteur.

## FIG 1

## FIG 2

## FIG 3

## FIG 4

**FIG 5**

**FIG 6**

(a)  (b)

**FIG 7**

**FIG 8**

**EP 3 324 434 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2013306991 A1
- US 9443792 B1
- US 2016056132 A1
- TW 405192 B